# EUROPÄISCHE PATENTSCHRIFT

(11) **EP 1 384 316 B1**
(45) Veröffentlichungstag und Bekanntmachung des Hinweises auf die Patenterteilung: **15.06.2005**
(21) Anmeldenummer: 02735179.0
(22) Anmeldetag: 26.03.2002
(51) Int. Cl.: H03F 1/30

(54) **VORRICHTUNG ZUM STEUERN EINES RUHESTROMS FÜR EINEN VERSTÄRKERTRANSISTOR UND VERSTÄRKERSCHALTUNG**
DEVICE FOR CONTROLLING A CLOSED CIRCUIT CURRENT FOR AN AMPLIFICATION TRANSISTOR AND AMPLIFICATION CIRCUIT
DISPOSITIF DE COMMANDE D'UN COURANT DE REPOS POUR TRANSISTOR AMPLIFICATEUR ET CIRCUIT AMPLIFICATEUR

(30) Priorität: 30.04.2001 DE 10121167
(43) Veröffentlichungstag der Anmeldung: 28.01.2004
(73) Patentinhaber: Infineon Technologies AG, 81669 München (DE)
(72) Erfinder: FORSTNER, Johann-Peter, 85643 Steinhoering (DE); SINNESBICHLER, Franz-Xaver, 83101 Thansau (DE)
(74) Vertreter: Stöckeler, Ferdinand, Dipl.-Ing.
(86) Internationale Anmeldenummer: PCT/EP2002/003391
(87) Internationale Veröffentlichungsnummer: WO 2002/089317

(56) Entgegenhaltungen:
- WO-A-01/22573
- US-A- 5 436 595
- US-A- 5 920 232

## Beschreibung

Die vorliegende Erfindung bezieht sich auf Verstärkerschaltungen und insbesondere auf Verstärkerschaltungen mit einer Vorrichtung zum Steuern eines Ruhestroms eines Verstärkertransistors.

Um den Wirkungsgrad von Leistungsverstärkern zu maximieren, welcher hauptsächlich die Sprechzeit eines Mobiltelefons beeinflußt, da die Batterieleistung begrenzt ist, werden dieselben üblicherweise bei niedrigen Ruheströmen betrieben. Diese Forderung besteht insbesondere bei linearen Leistungsverstärkern, die üblicherweise bei reduzierten Ausgangsleistungspegeln betrieben werden, derart, daß die Verstärkertransistor durch HF-Leistungsspitzen nicht in den nicht-linearen Bereich getrieben werden, was zu Nebenkanalaussendungen führen würde.

Die elektrischen Charakteristika eines Leistungsverstärkers, der in Klasse AB betrieben wird, hängen stark von dem Ruhestrom ab, d. h. dem Transistorstrom, der durch den DC-Arbeitspunkt bestimmt ist, wenn keine Mikrowellenleistung an den Eingang des Verstärkers angelegt wird. Aus diesem Grund muß der Ruhestrom über allen möglichen Betriebsbedingungen konstant bleiben, beispielsweise hinsichtlich der Temperatur und der Versorgungsspannung. Es sei darauf hingewiesen, daß insbesondere bei batteriebetriebenen Mobiltelefonen die Versorgungsspannung Vcc durchaus in Bereichen zwischen 5 V und 3 V variieren kann. Befindet sich das Mobiltelefon in der Ladestation, so wird die maximale Spannung Vcc von 5 V erreicht, während die Spannung deutlich bis auf etwa 3 V abnimmt, wenn die Batterie zur Neige geht.

In jüngster Zeit werden bevorzugt GaAs-basierte Heterobipolartransistoren (HBTs) als Endstufenverstärker in Mobiltelefonen eingesetzt. Solche Verstärkertransistoren haben eine hohe Basis-Emitter-Quellenspannung, die typischerweise bei 1,2 bis 1,3 V liegen kann. Darüber hinaus existiert bei Mobiltelefonen die weitere Anforderung, daß die Versorgungsspannung selten Werte von 5 V übersteigt. Außerdem existiert bei Mobiltelefonen die Möglichkeit, auf eine konstante Referenzspannungsquelle zuzugreifen, die lediglich Spannungswerte im Bereich zwischen 2,7 und 3 V liefert, die jedoch, im Gegensatz zur Versorgungsspannung, nur mit einem begrenzten, relativ kleinen Strom im Bereich unter 10 mA belastet werden kann. Zukünftige Trends gehen dahin, daß, um die Anforderungen an die Referenzspannungsquelle zu verringern, die Referenzspannungsquelle nur noch mit Strömen kleiner 1 mA belastet werden kann.

Unter diesen Voraussetzungen ist es üblicherweise schwierig, eine exakte Ruhestromeinstellung bezüglich der Temperatur zu liefern. Viele der gegenwärtig bekannten Bias-Schaltungen haben hier Probleme, da die verfügbaren Spannungsschwankungen nicht hoch genug sind, um eine konstante Ruhestromeinstellung zu schaffen.

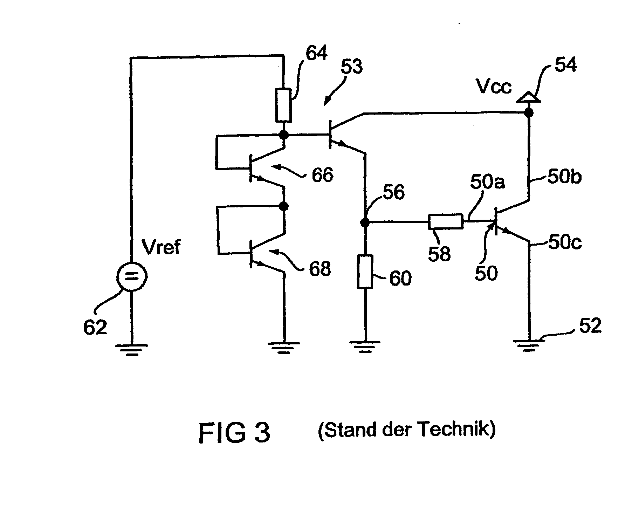

Fig. 3 zeigt eine bekannte Verstärkerschaltung mit Ruhestromtemperaturkompensation. Ausgangsseitig befindet sich ein Verstärkertransistor 50 in Bipolartechnik mit einem Steueranschluß (Basisanschluß) 50a, einem ersten Anschluß (Kollektoranschluß) 50b und einem zweiten Anschluß (Emitteranschluß) 50c. Der Emitteranschluß 50c des Verstärkertransistors 50 ist mit einer Schaltungsmasse 52 verbunden, während der Kollektor mit der Spannungsversorgung Vcc verbunden ist. Die Schaltung umfaßt einen weiteren Bipolartransistor 53, der als Emitterfolger verwendet wird, um geeignete Impedanzverhältnisse am Eingang des Verstärkertransistors 50 zu liefern. Der Emitterfolgertransistor 53 wird ebenfalls von der Versorgungsspannung 54 kollektorseitig versorgt, während sein Emitteranschluß mit einem Knoten 56 verbunden ist, der über einen ersten Widerstand 58 mit dem Steueranschluß 50a des Verstärkertransistors verbunden ist, und der über einen zweiten Widerstand 60 mit der Schaltungsmasse gekoppelt ist.

Eine konstante Referenzspannungsquelle 62 ist zwischen die Schaltungsmasse und einen weiteren Widerstand 64 geschaltet, wobei der andere Anschluß des Widerstands 64 mit dem Steueranschluß des Emitterfolgertransistors 52 verbunden ist. Der zweite Anschluß des Widerstands 64 ist ferner durch zwei als Dioden geschaltete Transistoren 66 und 68 mit der Schaltungsmasse verbunden. Jede Basis-Emitter-Diode der Transistoren 66 und 68 liefert einen Spannungsabfall von etwa 1,2 V, so daß der Steueranschluß des Emitterfolgertransistors auf etwa 2,4 V liegt. An der Basis-Emitter-Diode des Emitterfolgertransistors 52 fällt wiederum eine Spannung von etwa 1,2 V ab, so daß der Knoten 56 auf einem Potential von etwa 1,2 V liegt. Diese Spannung fällt an dem Widerstand 60 ab. Aufgrund der Tatsache, daß das Potential des Steueranschlusses 52 des Emitterfolgertransistors aufgrund der beiden diodenmäßig verwendeten Transistoren 66, 68 immer auf etwa 2,4 V liegt, ist der Strom durch den Widerstand 64 konstant, da die Spannungsquelle 62 eine Konstantspannungsquelle ist. Der Strom durch den ersten Anschluß 50b des Verstärkertransistors 50 und den zweiten Anschluß 50c des Verstärkertransistors 50 zur Schaltungsmasse ist somit ebenfalls konstant, da derselbe bei der in Fig. 5 gezeigten Schaltung dem Strom durch den Widerstand 64 folgt.

Temperaturvariationen des Kollektorstroms durch den Verstärkertransistor 50 treten dann auf, wenn die Basis-EmitterSpannung der beiden Transistoren 66 und 68 aufgrund von Temperaturschwankungen variiert. Dann variiert das Potential an dem Steueranschluß des Emitterfolgertransistors 52, was dazu führt, daß ein größerer oder kleinerer Strom durch den Widerstand 64 fließt, was wiederum dazu führt, daß sich auch der Kollektorstrom des Verstärkertransistors 50 ändert. Damit die Änderung des Stroms durch den Widerstand 64 aufgrund der temperaturveränderlichen Basis-Emitter-Spannungen der beiden Transistoren 66 und 68 nicht so stark ins Gewicht fällt, wird ein hoher Spannungsabfall am Widerstand 64 benötigt, da dann eine Basis-Emitter-Spannungsänderung aufgrund der Temperatur der Transistoren 66 und 68 hinsichtlich des Spannungsabfalls am (konstanten) Widerstand 64 nicht oder nicht so stark ins Gewicht fällt. Ist jedoch der Spannungsabfall an dem Widerstand 64 aufgrund vorgegebener kleiner Referenzspannungen klein, so wirken sich Änderungen der Basis-Emitter-Spannungen der Transistoren 66 und 68 wesentlich stärker auf den Strom durch den Widerstand 64 und damit auf den Kollektorstrom des Verstärkertransistors 50 aus.

Um die Schaltung, die in Fig. 3 gezeigt ist, betreiben zu können, wird somit eine Referenzspannungsquelle benötigt, die mehr als 2,4 V liefert, damit die Schaltung überhaupt zu arbeiten beginnt. Eine sinnvolle Temperaturkompensation wird jedoch erst bei Spannungswerten für die Referenzspannungsquelle von oberhalb 4 V erreicht, da dann der Spannungsabfall am Widerstand 64 größer ist als der Spannungsabfall an den Transistoren 66 und 68, welche temperaturvariabel sind, während der Widerstand 64 als über der Temperatur konstant angenommen werden kann.

Ein weiterer Nachteil der in Fig. 3 gezeigten Schaltung ist, daß lediglich eine Vorwärtssteuerung dahingehend vorgenommen wird, daß Temperaturvariationen in einem gewissen Bereich "verschleiert", jedoch nicht ausgeregelt werden.

Ein weiterer Nachteil der in Fig. 3 gezeigten Schaltung besteht darin, daß spezielle DC-Bias-Impedanzen für eine Verstärkerstufe bereitgestellt werden müssen, um unterschiedliche Betriebsbedingungen (linearer Modus, gesättigter Modus und linearer Modus bei niedrigen Ausgangsleistungspegeln) zu erreichen.

Die WO 01/22573 offenbart eine Schaltungsanordnung zur Regelung des Arbeitspunkts eines Leistungsverstärkers mit einem Stromspiegel, wobei ein Spiegeltransistor den Leistungstransistor bildet, während der andere Spiegeltransistor an seiner Basis mit einem zweistufigen Verstärker verbunden ist. Der zweistufige Verstärker umfasst zwei kaskadiert Transistoren in Emitterschaltung, wobei beide Emitter auf Masse gelegt sind. Das Ausgangssignal des zweistufigen Verstärkers wird über einen Transistor in Kollektorschaltung an die Basis des anderen Spielgeltransistors gelegt, um den Kollektorstrom durch diesen Spielgeltransistors rückkopplungsmäßig zu regeln.

Nachteilig an dieser Schaltungsanordnung ist die Tatsache, dass die Schaltung aufgrund der zwei kaskadierten Verstärkertransistoren eine Schwingneigung bei niedrigen Frequenzen besitzt, die lediglich durch einen Kondensator mit einem sehr hohen Kapazitätswert im nF-Bereich unterdrückt werden kann.

Weiterhin erfordert diese Schaltung unbedingt, dass die Versorgungsspannung der kaskadierten Verstärkertransistoren eine Konstantspannungsquelle ist, so dass eine Konstantspannungsquelle mit relativ hohem Stromoutput benötigt wird bzw. nicht die Flexibilität besteht, auf eine Konstantspannungsquelle zu verzichten und im Falle einer Telephonanwendung allein die Batteriespannung Vcc zu nehmen. Dies ist darauf zurückzuführen, dass die beiden kaskadierten Verstärkertransistoren emitterseitig auf Masse gelegt sind.

Das U.S.-Patent 5,436,595 offenbart einen Bipolartransistorverstärker mit einem Basis-Bias-Netzwerk. Im einzelnen ist die Basis eines Verstärkertransistors über ein resistives Netzwerk mit der Basis eines weiteren Transistors verbunden. Der Kollektorstrom durch den weiteren Transistor wird durch eine Rückkopplungsschleife gesteuert, damit der Arbeitspunktstrom durch den Verstärkertransistor konstant ist. Die Rückkopplungsschleife umfaßt einen Verstärkertransistor, der ein Potential an einem Kollektor des Hilfstransistors verstärkt. Der Strom durch den Verstärkertransistor wird durch eine Transistor/Widerstand-Kombination festgelegt und durch eine hochgenaue Band-Gap-Schaltung zur Erzeugung der Referenzspannung an der Basis des Transistors der Transistor/Widerstand-Kombination konstant gehalten.

Die Aufgabe der vorliegenden Erfindung besteht darin, eine flexiblere Vorrichtung zum Steuern eines Ruhestroms für einen Verstärkertransistor sowie eine Verstärkerschaltung zu schaffen.

Diese Aufgabe wird durch eine Vorrichtung gemäß Patentanspruch 1 oder durch eine Vorrichtung gemäß Patentanspruch 14 gelöst.

Der vorliegenden Erfindung liegt die Erkenntnis zugrunde, daß eine aktive Steuerschleife eingesetzt werden kann, um eine konstante Ruhestromeinstellung über einem breiten Temperaturbereich oder hinsichtlich von Parameterschwankungen der Transistoren zu schaffen. Erfindungsgemäß wird nicht der Kollektorstrom des Verstärkertransistors selbst unmittelbar rückkopplungsmäßig gesteuert, da der Zugang schaltungstechnisch aufwendig ist, zumal in diesem Bereich üblicherweise der HF-Eingang ist, da die zu verstärkenden HF-Signale an den Steueranschluß des Verstärkertransistors anzulegen sind.

Erfindungsgemäß wird ein Spiegeltransistor so mit dem Verstärkertransistor gekoppelt, daß ein Stromspiegel gebildet ist, so daß der Kollektorstrom in den Spiegeltransistor identisch zu dem Kollektorstrom in den Verstärkertransistor ist bzw., wenn die Transistoren nicht die gleiche Größe haben, mit der Transistorfläche skaliert ist, d. h. zu dem Kollektorstrom durch den Spiegeltransistor proportional ist. Zur rückkopplungsmäßigen Steuerung des Kollektorstroms, derart, daß derselbe von Temperaturvariationen bzw. Bauelementeparametern unabhängig ist, ist eine Erfassungseinrichtung vorgesehen, um die Spannung an dem Kollektoranschluß des Spiegeltransistors zu erfassen, und um ein Ausgangssignal als Reaktion auf die Spannung an dem Kollektoranschluß des Spiegeltransistors zu liefern.

Die Erfassungseinrichtung ist als Differenzverstärkertransistor ausgeführt, dessen Transistoren nicht auf Masse gelegt sind, sondern entweder über einen Widerstand (im Falle von VCC als Versorgungsspannung) oder über eine Stromquelle (im Falle einer Konstantspannungsquelle als Versorgungsspannung), die bei konstanter Versorgungsspannung auch ein Widerstand sein kann, mit der Masse verbunden. Damit besitzt die Schaltung die Option, dass der Differenzverstärker floaten kann und damit Spannungsschwankungen der Versorgungsspannung folgen kann, so dass optional auch auf die Konstantspannungsquelle verzichtet werden kann.

Das Ausgangssignal der Erfassungseinrichtung wird einer Rückkopplungseinrichtung zugeführt, um das Ausgangssignal der Erfassungseinrichtung zu empfangen und um ein Rückkopplungssignal zu dem Steueranschluß des Spiegeltransistors zu liefern, damit der Spiegeltransistor so gesteuert wird, daß der Kollektorstrom temperaturunabhängig ist.

Die Vorrichtung zum Steuern des Ruhestroms gemäß der vorliegenden Erfindung umfaßt ferner eine resistive Einrichtung mit zwei Anschlüssen, wobei der erste Anschluß der resistiven Einrichtung mit einer Spannung verbindbar ist, und wobei der zweite Anschluß der resistiven Einrichtung mit dem Kollektoranschluß des Spiegeltransistors verbunden ist.

Gemäß einem ersten Ausführungsbeispiel der vorliegenden Erfindung ist die Spannung an der resistiven Einrichtung eine konstante Referenzspannung. Alternativ kann jedoch gemäß einem anderen Ausführungsbeispiel der vorliegenden Erfindung auch die stark schwankende Versorgungsspannung verwendet werden, da, im Gegensatz zum Stand der Technik, Versorgungsspannungsschwankungen aufgrund der Rückkopplungsschleife ausgeregelt werden.

Gemäß der vorliegenden Erfindung kann, unabhängig davon, ob eine Konstantspannungsquelle oder eine Versorgungsspannungsquelle an die resistive Einrichtung angelegt wird, für die Erfassungseinrichtung ein Differenzverstärker eingesetzt werden, wobei in einen Steueranschluß eines der Transistoren des Differenzverstärkers die Spannung am Kollektor des Spiegeltransistors eingegeben wird, während die Spannung an dem nicht-invertierenden Ausgang des Differenzverstärkers der Rückkopplungseinrichtung zugeführt wird. Der Knoten, an dem beide Transistoren miteinander verbunden sind, ist nicht auf Masse gelegt, sondern auf einem anderen Potential, so dass dieser Knoten mit Schwankungen der Versorgungsspannung floaten kann, falls auf die Konstantspannungsquelle verzichtet wird.

Bei dem bevorzugten Ausführungsbeispiel der vorliegenden Erfindung ist die Rückkopplungseinrichtung als Emitterfolgertransistor ausgeführt, dessen Emitter mit dem Steueranschluß des Spiegeltransistors elektrisch verbunden ist, während sein Steueranschluß mit der Spannungserfassungseinrichtung gekoppelt ist.

Die erfindungsgemäße Schaltung ist dahingehend vorteilhaft, daß Kollektorstromschwankungen aufgrund der rückkopplungsmäßigen Natur der Schaltung ausgeregelt werden, so daß bei bevorzugten Ausführungsbeispielen der vorliegenden Erfindung auf eine Konstantspannungsquelle sogar verzichtet werden kann und die resistive Einrichtung statt dessen mit der stark schwankenden Versorgungsspannung verbunden wird, solange die Schwankungen der Versorgungsspannung auch der Erfassungseinrichtung zugeführt werden.

Ein weiterer Vorteil der erfindungsgemäßen Vorrichtung besteht darin, daß kleinere Spannungspegel für die Konstantspannungsquelle oder die Versorgungsspannungsquelle Vcc ausreichend sind. Insbesondere mußte die Versorgungsspannung oder Konstantspannungsquelle im Stand der Technik deutlich größer als das Doppelte der Basis-Emitter-Spannung eines Bipolartransistors sein. Erfindungsgemäß muß die Versorgungsspannung oder Konstantspannung gemäß der vorliegenden Erfindung lediglich größer als zwei Basis-Emitter-Spannungsabfall-Einheiten sein, wobei prinzipiell auch Werte knapp oberhalb dieses Grenzwerts ausreichen, da Basis-Emitter-Spannungsschwankungen aufgrund von veränderlichen Temperaturen ohnehin rückkopplungsmäßig ausgeregelt werden.

Bevorzugte Ausführungsbeispiele der vorliegenden Erfindung werden nachfolgend bezugnehmend auf die beiliegenden Zeichnungen näher erläutert. Es zeigen:
- Fig. 1: eine Verstärkerschaltung mit einer Vorrichtung zum Steuern eines Ruhestroms mit einem Differenzverstärker als Erfassungseinrichtung und einer Konstantspannungsquelle;
- Fig. 2: eine Verstärkerschaltung mit einer Vorrichtung zum Steuern eines Ruhestroms mit einem Differenzverstärker als Erfassungseinrichtung und lediglich einer Versorgungsspannung Vcc; und
- Fig. 3: eine bekannte Verstärkerschaltung mit einer bekannten Vorrichtung zum Steuern eines Ruhestroms.

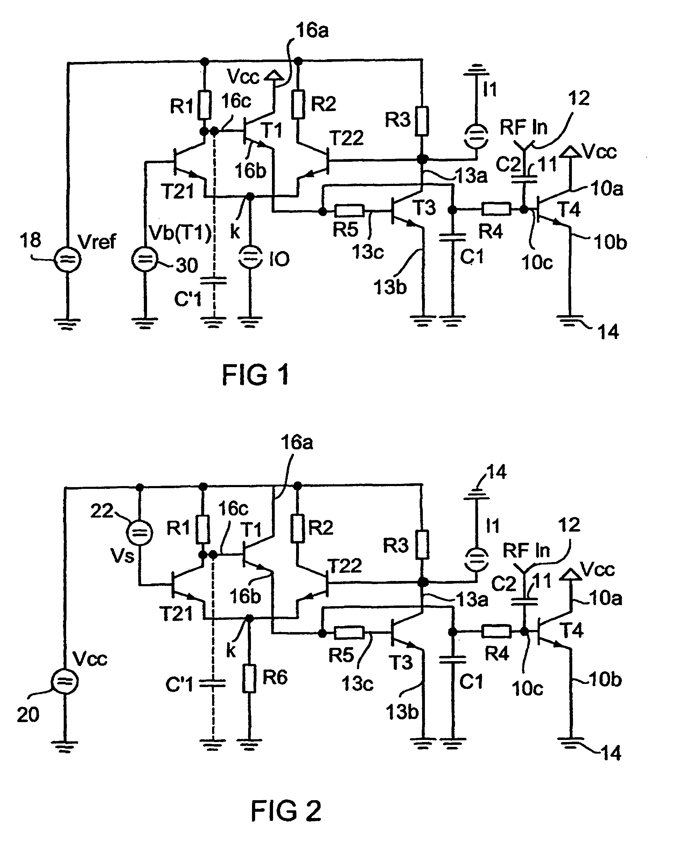

Fig. 1 zeigt eine erfindungsgemäße Verstärkerschaltung mit einer Vorrichtung zum Steuern eines Ruhestroms für einen Verstärkertransistor T4. Der Verstärkertransistor T4 umfaßt einen ersten Anschluß 10a, einen zweiten Anschluß 10b sowie einen Steueranschluß 10c. Bei bevorzugten Ausführungsbeispielen der vorliegenden Erfindung sind die Transistoren als Bipolartransistoren und insbesondere als Heterobipolartransistoren auf GaAs (HBTs) ausgeführt. In diesem Fall ist der Steueranschluß 10c der Basisanschluß, während der erste Anschluß 10a der Kollektoranschluß und der zweite Anschluß 10b der Emitteranschluß des Verstärkertransistors T4 ist. Der Verstärkertransistor T4 bildet beispielsweise eine Verstärkerstufe oder die Endstufe einer Kette von kaskadierten Verstärkern. Alternativ könnte er auch die Eingangsstufe einer solchen Kette sein. Wie es in Fig. 1 schematisch dargestellt ist, kann der Basisanschluß 10c über einen Serienkondensator 11 mit einer Quelle 12 verbunden sein, um das zu verstärkende Nutzsignal dem Verstärkertransistor T4 zuzuführen, damit es verstärkt wird.

Der Verstärkertransistor T4 ist mit einem Spiegeltransistor T3 so verbindbar, daß sich ein Stromspiegel zwischen dem Spiegeltransistors T3 und dem Verstärkertransistor T4 bildet. Insbesondere ist der Steueranschluß 10c des Verstärkertransistors T4 mit einem Steueranschluß 13c des Spiegeltransistors T3 über ein Impedanznetzwerk verbunden, das eine T-Schaltung mit zwei Widerständen R4 und R5 in den Längszweigen und einen Kondensator C1 im Querzweig umfaßt, gekoppelt. Der Spiegeltransistor T3 umfaßt ferner einen ersten Anschluß 13a und einen zweiten Anschluß 13b. Wenn der Spiegeltransistor ebenfalls als Bipolartransistor ausgeführt ist, ist der erste Anschluß 13a desselben der Kollektoranschluß, während der zweite Anschluß 13b desselben der Emitteranschluß ist. Wie es in Fig. 1 gezeigt ist, sind die Emitteranschlüsse der beiden Transistoren T3 und T4 mit einer Schaltungsmasse 14 verbunden. Es sei darauf hingewiesen, daß es wesentlich ist, daß der Spiegeltransistor T3 und der Verstärkertransistor T4 eine Stromspiegelschaltung bilden. Hierzu müßte das Widerstandsnetzwerk bestehend aus R5, R4 und C1 nicht unbedingt vorhanden sein. Es würde lediglich ausreichen, daß die beiden Steueranschlüsse miteinander verbunden sind, derart, daß der Kollektorstrom durch den Transistor T3 identisch zum Kollektorstrom durch den Transistor T4 ist bzw. entsprechend der Transistorgröße skaliert ist. Generell gilt bei Stromspiegeln, daß der Kollektorstrom durch den Verstärkertransistor proportional zum Kollektorstrom durch den Spiegeltransistor ist, wobei diese Proportionalität entweder in einer Gleichheit besteht, wenn beide Transistoren gleich dimensioniert sind, oder in einer linearen Abhängigkeit mit einem Faktor gemäß den geometrischen Flächen der Transistoren.

Der erste Anschluß 13a des Spiegeltransistors T3 ist über einen Widerstand R3, der die resistive Einrichtung bildet, mit einer Spannungsquelle verbunden, die bei dem in Fig. 1 gezeigten Ausführungsbeispiel eine Konstantreferenzspannungsquelle 18 ist. Im Falle einer bipolaren Ausführung beträgt das Potential an dem Kollektoranschluß des Spiegeltransistors T3 aufgrund des Basis-Emitter-Spannungsabfalls des Transistors T2 etwa 1,6 V im Gegensatz zu etwa 2,4 V bei der in Fig. 5 gezeigten bekannten Schaltung, so daß kleinere Referenzspannungswerte ausreichen.

Es sei darauf hingewiesen, dass die oben angegebenen Werte für GaAs-HBTs gelten. Ein Basis-Emitter-Spannungsabfall für SiGe-Transistoren liegt bei etwa 0,6 V. Für InP-Transistoren beträgt dieser Wert 0,7 V.

Ein Steueranschluß 16c des Transistors T1 ist mit einem Ausgang der Spannungserfassungseinrichtung gekoppelt, die einen Differenzverstärker umfasst, auf den später eingegangen wird. Ein erster Anschluß 16a des Transistors T1 ist mit einer Spannungsversorgung Vcc verbunden, während der zweite Anschluß 16b des Transistors T1, der als Emitterfolger fungiert, mit dem Steueranschluß des Spiegeltransistors 13c entweder direkt oder, wie es in Fig. 1 gezeigt ist, optional über den Widerstand R5 verbunden ist. Der Emitterfolgertransistor T1 bildet eine Rückkopplungseinrichtung zum Empfangen des Ausgangssignals der Erfassungseinrichtung, und zum Liefern eines Rückkopplungssignals, d. h. der Emitterspannung des Transistors T1, zu dem Spiegeltransistor, um die Rückkopplungsschleife zu schließen.

Bei der in Fig. 1 gezeigten Schaltung bilden somit die beiden Transistoren T3 und T4 eine Stromspiegelkonstellation. Die Transistoren T21 und T22 wird zum Erfassen der Kollektorspannung von T3 verwendet. Der Transistor T1 wirkt als Emitterfolger. Die Rückkopplungsschleife um den Spiegeltransistor T3 wird durch Verbinden des Kollektors T3 mit der Basis von T22 geschlossen, dessen Kollektor wiederum mit der Basis von T1 verbunden ist, dessen Emitter schließlich wieder mit der Basis von T3 verbunden ist.

Die Aufgabe der Schaltung besteht darin, einen konstanten Kollektorstrom in den Verstärkertransistor T4 zu bringen, der Teil einer HF-Verstärkerkette sein kann. Dies wird erreicht, indem ein konstanter Strom in den Spiegeltransistor T3 injiziert wird, derart, daß auch ein konstanter Strom in den Kollektor 10a des Transistors T4 gebracht wird, da diese beiden Transistoren einen Stromspiegel bilden. Der Kollektorstrom von dem Transistor T3 ist konstant, wenn der Spannungsabfall über der resistiven Einrichtung R3 konstant ist, da der Basisstrom in den Transistor T22 wesentlich kleiner als der Kollektorstrom des Transistors T3 ist.

Der Differenzverstärker der Spannungserfassungseinrichtung umfasst die Transistoren T21 und T22 sowie die Widerstände R1 und R2. Der Differenzverstärker dient als Erfassungseinrichtung zum Erfassen der Spannung an dem ersten Anschluß 13a des Spiegeltransistors T3, da diese Spannung die Steuerspannung für den Transistor T22 ist. Abhängig von der Steuerspannung des Transistors T22, welche eine Eingangsspannung für den Differenzverstärker ist, ergibt sich eine Ausgangsspannung des Differenzverstärkers an dem Kollektor des Transistors T21, welcher wieder mit dem Steueranschluß des Emitterfolgertransistors T1 verbunden ist, der als Rückkopplungseinrichtung fungiert.

Insbesondere besteht der Differenzverstärker aus dem ersten Transistor T21 und dem zweiten Transistor T22, wobei die Emitter beider Transistoren an einem Knoten K miteinander verbunden sind. Der Knoten K ist jedoch nicht auf Masse gelegt, sondern auf einem anderen Potential als dem Massepotential. In Fig. 1 ist dies durch die Stromquelle I0 symbolisiert. Da Vref 18 konstant ist, kann die Stromquelle 10 durch einen Widerstand oder einen als Widerstand verwendeten Transistor realisiert werden.

Die Transistoren T3 und T4 bilden, wie ausgeführt, eine Stromspiegelkonstellation. Die Schleife zum Steuern des Kollektorstroms durch den Spiegeltransistor T3 wird geschlossen, indem der Kollektor des Transistors T3 mit der Basis des Transistors T22 verbunden wird. Der Ausgang des Differenzverstärkers, d. h. der Kollektor des Transistors T21, ist mit der Basis des Rückkopplungstransistors T1 verbunden, dessen Emitter, wie es ausgeführt worden ist, mit dem Steueranschluß 13c des Spiegeltransistors T3 verbunden ist.

Das Ziel darin, einen konstanten Kollektorstrom in den Verstärkertransistor T4 zu erreichen, der Teil einer HF-Verstärkerkette sein kann. Dies wird erreicht, indem ein konstanter Strom in den Spiegeltransistor T3 injiziert wird. Der Kollektorstrom von T3 ist konstant, wenn der Spannungsabfall an dem Widerstand R3 konstant ist, da der Basisstrom in den Transistor T22 viel kleiner als der Kollektorstrom in den Spiegeltransistor T3 ist.

Nachfolgend seien folgende Zahlenwerte angenommen. Es sei angenommen, daß die Basisspannung an dem Transistor T21 2,0 V beträgt, wie es durch eine Spannungsquelle 30 angedeutet ist. Darüber hinaus wird angenommen, daß die Referenzspannungsquelle 18 einen Wert von 2,8 V hat und die Stromquelle I1 auf Null gesetzt ist. Die Basisspannung an dem Transistor T21 bringt die Emitterspannung an den Transistoren T21 und T22 dazu, um einen Basis-Emitter-Spannungsabfall niedriger zu sein, wobei für den Basis-Emitter-Spannungsabfall wieder ein Wert zwischen 1,2 und 1,3 V für GaAs anzusetzen ist. Wenn die Verstärkung des Differenzverstärkers hoch ist, was wiederum durch die Widerstände R1 und R2 und den Strom I1 eingestellt werden kann, wird davon ausgegangen, daß die Basisspannung an dem Transistor T22 gleich Vb(T21) ist. Dies bedeutet, daß der Spannungsabfall über R3 konstant ist, wodurch ein konstanter Kollektorstrom in den Spiegeltransistor T3 und damit auch in den Verstärkertransistor T4 injiziert wird.

Es sei angenommen, daß der Spiegeltransistor T3 und damit auch der Verstärkertransistor T4 aufgrund von Temperaturvariationen, Teile-zu-Teile-Variationen etc. die Tendenz hat, mehr Kollektorstrom zu ziehen. In diesem Fall hat die Kollektorspannung Vc an dem Spiegeltransistor T3 die Tendenz, zu fallen, was ebenfalls wiederum dazu führt, daß auch die Spannung an dem Kollektor des Transistors T21 abfällt, da dieser der nicht-invertierende Ausgang des Differenzverstärkers ist. Als Ergebnis fällt die Emitterspannung des Transistors T1 ab, da dieselbe der Basisspannung an dem Transistor T1 folgt. Dies führt wiederum dazu, daß die Basis-Emitter-Spannung des Spiegeltransistors T3 reduziert wird, bis der Kollektorstrom durch den Spiegeltransistor T3 wieder auf seinem ursprünglichen gewünschten Wert ist. Wenn der Spiegeltransistor T3 dagegen die Tendenz besitzt, weniger Strom zu ziehen, ist das Verhalten genau umgekehrt, d. h. die Basis-Emitter-Spannung des Spiegeltransistors T3 wird solange erhöht, bis der Kollektorstrom wieder auf seinen ursprünglichen gewünschten Wert angestiegen ist.

Die Konstantstromquelle I1 kann dazu verwendet werden, den Kollektorstrom von T4 und T5 gesteuert zu variieren.

Eine äquivalente Stromsteuerung kann erreicht werden, indem die Basisspannung des Transistors T21, d. h. die Spannungsquelle 30, gesteuert variiert wird. Wenn die Basisspannung des Transistors T21 erhöht wird, folgt das Kollektorpotential des Spiegeltransistors. Dies führt dazu, daß der Spannungsabfall über R3 reduziert wird und daß damit der Kollektorstrom in den Spiegeltransistor abfällt.

Das in Fig. 2 gezeigte Ausführungsbeispiel unterscheidet sich von dem in Fig. 1 gezeigten Ausführungsbeispiel dadurch, daß die Referenzspannungsquelle 18 von Fig. 1 durch die Versorgungsspannungsquelle 20 Vcc ersetzt ist, und daß, um höhere Versorgungsspannungen zuzulassen, optional die Spannungsquelle 22 zwischen der Versorgungsspannung und der Basis des Differenzverstärkertransistors T21 angeordnet ist. Wenn auf die Konstantreferenzspannungsquelle verzichtet wird, ist es von Bedeutung, daß die Basis des Transistors T21 hinsichtlich ihres Potentials mit dem Versorgungsspannungspotential schwankt. In diesem Fall folgt die Spannung an dem Kollektor des Transistors T3 der Differenz aus Vcc und Vs, so daß der Spannungsabfall über R3 wieder konstant ist, was bewirkt, daß ein konstanter Strom in die Transistoren T3 und damit auch T4 injiziert wird. Statt der Stromquelle 10 von Fig. 1 kann bei dem in Fig. 2 gezeigten Ausführungsbeispiel mit schwankender Versorgungsspannung Vcc der Widerstand R6 verwendet werden.

Es sei darauf hingewiesen, daß es bevorzugt wird, den Verstärkertransistor T4 zusammen mit der restlichen Schaltung monolithisch zu integrieren, da Stromspiegelanordnungen um so besser funktionieren, je gleicher die Charakteristika des Spiegeltransistors und des Verstärkertransistors sind. Alternativ wird eine monolithische Integration sämtlicher Schaltungen ohne den Verstärkertransistor bevorzugt, wenn der Verstärkertransistor beispielsweise Teil eines anderen Chips ist und die Stromsteuerschaltung gewissermaßen nachgerüstet werden muß.

Zur Dämpfung einer Schwingungsneigung der Rückkopplungsschleife ist der Kondensator C1 zwischen der Masse 14 und dem Ausgang 16b der Rückkopplungseinrichtung, d. h. dem Emitteranschluß des Transistors T1, vorgesehen. Alternativ oder zusätzlich ist ein Kondensator C1' zwischen den Eingang 16c der Rückkopplungseinrichtung T1 und die Schaltungsmasse 14 geschaltet ist. Bei der erfindungsgemäßen Schaltung genügen kleine Kapazitätswerte, die im Bereich von 1 und 10 pF liegen können.

Die erfindungsgemäße Vorrichtung ermöglicht somit die Verwendung von Referenzspannungsquellen mit geringen Spannungswerten oder sogar den Verzicht auf eine Konstantspannungsquelle, wenn statt der Konstantspannungsquelle eine schwankende Schaltungsversorgungsspannungsquelle eingesetzt wird. Kollektorströme durch den Spiegeltransistor werden durch die Rückkopplungsschleife automatisch auf einen konstanten Ruhestromwert geregelt, welcher den Arbeitspunkt des Verstärkertransistors (T4) festlegt.

Bezugszeichenliste
- 10a: erster Anschluß des Verstärkertransistors
- 10b: zweiter Anschluß des Verstärkertransistors
- 10c: Steueranschluß des Verstärkertransistors
- 11: Koppelkondensator
- 12: Quelle
- 13a: erster Anschluß des Spiegeltransistors
- 13b: zweiter Anschluß des Spiegeltransistors
- 13c: Steueranschluß des Spiegeltransistors
- 14: Schaltungsmasse
- 16a: erster Anschluß des Rückkopplungstransistors
- 16b: zweiter Anschluß des Rückkopplungstransistors
- 16c: Steueranschluß des Rückkopplungstransistors
- 18: Referenzspannungsquelle
- 20: Schaltungsversorgungsspannungsquelle Vcc
- 22: Konstantspannungsquelle
- 30: Basisspannungsquelle für den ersten Differenzverstärkertransistor
- 50: Verstärkertransistor
- 50a: Basisanschluß des Verstärkertransistors
- 50b: Kollektoranschluß des Verstärkertransistors
- 50c: Emitteranschluß des Verstärkertransistors
- 52: Schaltungsmasse
- 53: Emitterfolgertransistor
- 54: Schaltungsversorgungsspannung Vcc
- 56: Knoten
- 58: Widerstand
- 60: Widerstand
- 62: Referenzspannungsquelle
- 64: Widerstand
- 66: erste Basis-Emitter-Diode
- 68: zweite Basis-Emitter-Diode

## Patentansprüche

1. Vorrichtung zum Steuern eines Ruhestroms für einen Verstärkertransistor (T4), wobei der Verstärkertransistor (T4) einen Steueranschluß (10c) und einen ersten (10a) und einen zweiten (10b) Anschluß aufweist, die angeordnet sind, damit der Ruhestrom über den ersten und den zweiten Anschluß (10a, 10b) durch den Verstärkertransistor (T4) fließen kann, mit folgenden Merkmalen:
einem Spiegeltransistor (T3) mit einem Steueranschluß (13c), einem ersten Anschluß (13a) und einem zweiten Anschluß (13b), der so mit dem Verstärkertransistor (T4) verbindbar ist, daß der Spiegeltransistor (T3) mit dem Verstärkertransistor (T4) einen Stromspiegel bildet, so daß der Ruhestrom des Verstärkertransistors (T4) gleich oder proportional zu dem Strom durch den ersten und zweiten Anschluß (13a, 13b) des Spiegeltransistors (13) ist;
einer Erfassungseinrichtung (T21, T22, R1, R2) zum Erfassen der Spannung an dem ersten Anschluß (13a) des Spiegeltransistors (T3) und zum Liefern eines:Ausgangssignals als Reaktion auf die Spannung an dem ersten Anschluß (13a) des Spiegeltransistors (13), wobei die Erfassungseinrichtung einen Differenzverstärker (T21, T22, R1, R2) mit einem ersten Differenzverstärkertransistor (T21) und einem zweiten Differenzverstärkertransistor (T22) aufweist, wobei ein Steueranschluß des zweiten Differenzverstärkertransistors (T22) mit dem ersten Anschluß (13a) des Spiegeltransistors (T3) verbunden ist,
wobei an einem Anschluß des ersten Differenzverstärkertransistors (T21) das Ausgangssignal der Erfassungseinrichtung ausgebbar ist, und wobei zwischen einem Knoten (K), an dem der erste Differenzverstärkertransistor (T21) mit dem zweiten Differenzverstärkertransistor (T22) verbunden ist, und dem Massepotential ein Widerstand (R6) geschaltet ist ;
einer Rückkopplungseinrichtung (T1) zum Empfangen des Ausgangssignals der Erfassungseinrichtung (T21, T22, R1, R2) und zum Liefern eines Rückkopplungssignals, das von dem Ausgangssignal der Erfassungseinrichtung abhängt, zu dem Steueranschluß (13c) des Spiegeltransistors (T3); und
einer resistiven Einrichtung (R3) mit zwei Anschlüssen, wobei der erste Anschluß der resistiven Einrichtung (R3) mit einer Spannung (18, 20) verbindbar ist, und wobei der zweite Anschluß der resistiven Einrichtung (R3) mit dem ersten Anschluß (13a) des Spiegeltransistors verbunden ist, so daß ein Strom durch die resistive Einrichtung (R3) aufgrund der Spannung (18, 20) durch ein Signal an dem Steueranschluß (13c) des Spiegeltransistors (13) steuerbar ist,
wobei die Spannung, mit der der erste Anschluß der resistiven Einrichtung (R3) verbindbar ist, eine Versorgungsspannung (Vcc) ist, mit der die Rückkopplungseinrichtung (T1) und der Verstärkertransistor (T4) versorgbar sind, und
wobei die Erfassungseinrichtung mit einer Spannung (22) versorgbar ist, deren Variation über der Zeit der Variation über der Zeit der Versorgungsspannung (Vcc) (20) entspricht.

2. Vorrichtung gemäß Anspruch 1,
bei der die Rückkopplungseinrichtung einen Rückkopplungstransistor (T1) mit einem Steueranschluß (16c) und einem ersten und einem zweiten Anschluß (16a, 16b) aufweist, wobei an den Steueranschluß (16c) das Ausgangssignal der Erfassungseinrichtung (T21, T22, R1, R2) angeschlossen ist, wobei der erste Anschluß (16a) mit der Versorgungsspannung (Vcc) für die Vorrichtung verbindbar ist, wobei an den zweiten Anschluß (16b) das Rückkopplungssignal ausgebbar ist, und wobei der zweite Anschluß (16b) mit dem Steueranschluß (13c) des Spiegeltransistors (T3) verbunden ist.

3. Vorrichtung gemäß Anspruch 2, bei der die Rückkopplungseinrichtung einen Emitterfolger bzw. einen Source-Folger aufweist.

4. Vorrichtung gemäß einem der vorhergehenden Ansprüche,
bei der die Erfassungseinrichtung ferner eine erste (R1) und eine zweite resistive Einrichtung (R2) aufweist, die zwischen der Spannungsquelle (18, 20) und dem ersten Verstärkertransistor (T21) bzw. dem zweiten Verstärkertransistor (T22) geschaltet sind.

5. Vorrichtung gemäß einem der vorhergehenden Ansprüche, die ferner folgendes Merkmal aufweist:
eine Einrichtung (I1) zum Einprägen eines zusätzlichen Stroms in den ersten Anschluß (13a) des Spiegeltransistors (T3).

6. Vorrichtung gemäß Anspruch 5, die ferner folgendes Merkmal aufweist:
eine Einrichtung (30) zum Anlegen einer Spannung an den Steueranschluß des ersten Differenzverstärkertransistors (T21).

7. Vorrichtung gemäß einem der vorhergehenden Ansprüche,
bei der der Steueranschluß (13c) des Spiegeltransistors (T3) mit dem Steueranschluß (10c) des Verstärkertransistors (T4) über ein Impedanznetzwerk (R4, R5, C1) verbindbar ist,
bei der der zweite Anschluß (13b) des Spiegeltransistors mit einer Schaltungsmasse (14) verbindbar ist, und
bei der der zweite Anschluß (10b) des Verstärkertransistors (T4) mit der Masse (14) verbindbar ist.

8. Vorrichtung nach einem der vorhergehenden Ansprüche, die ferner eine Dämpfungseinrichtung (C1; C1') zum Dämpfen einer Schwingneigung der Vorrichtung aufweist.

9. Vorrichtung nach Anspruch 10, bei der die Dämpfungseinrichtung ein Kondensator (C1) ist, der zwischen die Basis des Spiegeltransistors (T3) und eine Schaltungsmasse (14) geschaltet ist.

10. Vorrichtung nach Anspruch 10, bei der die Dämpfungseinrichtung ein Kondensator (C1') ist, der zwischen den Eingang (16c) der Rückkopplungseinrichtung (T1) und eine Schaltungsmasse (14) geschaltet ist.

11. Vorrichtung nach Anspruch 11 oder 12, bei der der Kondensator einen Kapazitätswert zwischen 1 und 10 pF aufweist.

12. Verstärkerschaltung mit folgenden Merkmalen:
einem Verstärkertransistor (T4) mit einem Steueranschluß (10c) und einem ersten und einem zweiten Anschluß (10a, 10b), die angeordnet sind, damit ein Ruhestrom über den ersten und den zweiten Anschluß (10a, 10b) durch den Verstärkertransistor (T4) fließen kann;
einer Vorrichtung zum Steuern des Ruhestroms des Verstärkertransistors (T4) gemäß einem der Ansprüche 1 bis 12,
wobei der erste Anschluß (10c) des Verstärkertransistors mit der Versorgungsspannung (Vcc) verbindbar ist;
wobei der zweite Anschluß (10b) des Verstärkertransistors mit einer Schaltungsmasse (14) verbindbar ist;
wobei der Steueranschluß (13c) des Spiegeltransistors (T3) mit dem Steueranschluß (10c) des Verstärkertransistors (T4) verbunden ist; und
wobei ein Nutzsignal (RF IN) an den Steueranschluß (10c) des Verstärkertransistors (T4) anlegbar ist, so daß an dem ersten Anschluß (10a) des Verstärkertransistors ein verstärktes Nutzsignal ausgebbar ist.

13. Verstärkerschaltung gemäß Anspruch 14, bei der der Verstärkertransistor (T4) und der Spiegeltransistor (T3) Bipolartransistoren sind.

14. Verstärkerschaltung gemäß Anspruch 15, bei der der Verstärkertransistor (T4) und der Spiegeltransistors (T3) Heterobipolartransistoren sind.

15. Verstärkerschaltung gemäß einem der Ansprüche 14 bis 16, bei der der Verstärkertransistor (T4) und der Spiegeltransistor (T3) als eine monolithisch integrierte Mikrowellenschaltung ausgeführt sind.

16. Verstärkerschaltung gemäß einem der Ansprüche 14 bis 17, die vollständig als monolithisch integrierte Mikrowellenschaltung ausgeführt ist.

17. Verstärkerschaltung nach einem der Ansprüche 14 bis 18, bei der der Steueranschluß (13c) des Spiegeltransistors (T3) über ein Impedanznetzwerk (R4, R5, C1) mit dem Steueranschluß (10c) des Verstärkertransistors (T4) verbunden ist.

## Claims

1. Device for controlling a quiescent current for an amplifier transistor (T4), the amplifier transistor (T4) having a control terminal (10c) and a first (10a) and a second (10b) terminal, which are arranged so that the quiescent current can flow through the amplifier transistor (T4) via the first and the second terminal (10a, 10b), comprising:
an mirror transistor (T3) with a control terminal (13c), a first terminal (13a) and a second terminal (13b), which can be so connected to the amplifier transistor (T4) that the mirror transistor (T3) forms a current mirror with the amplifier transistor (T4) so that the quiescent current of the amplifier transistor (T4) is equal to or proportional to the current through the first and second terminal (13a, 13b) of the mirror transistor (T3);
a detector (T21, T22, R1, R2) for detecting the voltage at the first terminal (13a) of the mirror transistor (T3) and for supplying an output signal in response to the voltage at the first terminal (13a) of the mirror transistor (T3), wherein the detector has a differential amplifier (T21, T22, R1, R2) with a first differential amplifier transistor (T21) and a second differential amplifier transistor (T22),
wherein a control terminal of the second differential amplifier transistor (T22) is connected to the first terminal (13a) of the mirror transistor (T3), wherein the output signal of the detector can be extracted at a terminal of the first differential amplifier transistor (T21), and
wherein a resistor (R6) is connected between a node (K) where the first differential amplifier transistor (T21) is interconnected with the second differential amplifier transistor (T22) and the ground potential;
a feedback unit (T1) for receiving the output signal of the detector (T21, T22, R1, R2) and for supplying a feedback signal, which depends on the output signal of the detector, to the control terminal (13c) of the mirror transistor (T3); and
a resistive unit (R3) with two terminals, the first terminal of the resistive unit (R3) being connectable to a voltage (18, 20) and the second terminal of the resistive unit (R3) being connected to the first terminal (13a) of the mirror transistor, so that a current through the resistive unit (R3) due to the voltage (18, 20) is controllable by a signal at the control terminal (13c) of the mirror transistor (T3),
wherein the voltage to which the first terminal of the resistive unit (R3) is conntectable, is a supply voltage (Vcc) with which the feedback unit (R3) and the amplifier transistor (T4) can be supplied, and
wherein the detector can be supplied with a voltage (22), whose variation with time corresponds to the variation with time of the supply voltage (Vcc) (20).

2. Device according to claim 1,
wherein the feedback unit has a feedback transistor (T1) with a control terminal (16c) and a first and a second terminal (16a, 16b), wherein the output signal of the detector (T21, T22, R1, R2) is connected to the control terminal (16c), wherein the first terminal (16a) can be connected to the supply voltage (Vcc) for the device, wherein the feedback signal can be extracted at the second terminal (16b), and wherein the second terminal (16b) is connected to the control terminal (13c) of the mirror transistor (T3).

3. Device according to claim 2, wherein the feedback unit has an emitter follower or a source follower.

4. Device according to one of the preceding claims,
wherein the detector also has a first (R1) and a second resistive unit (R2), which are respectively circuited between the voltage source (18, 20) and the first amplifier transistor (T21) and between the voltage source (18, 20) and the second amplifier transistor (T22).

5. Device according to one of the preceding claims, which also comprises:
a unit (I1) for imposing an additional current on the first terminal (13a) of the mirror transistor (T3).

6. Device according to claim 5, which also comprises:
a unit (30) for applying a voltage to the control terminal of the first differential amplifier transistor (T21).

7. Device according to one of the preceding claims,
wherein the control terminal (13c) of the mirror transistor (T3) is connectable to the control terminal (10c) of the amplifier transistor (T4) via an impedance network (R4, R5, C1),
wherein the second terminal (13b) of the mirror transistor is connectable to a circuit ground (14), and
wherein the second terminal (10b) of the amplifier transistor (T4) is connectable to ground (14).

8. Device according to one of the preceding claims, which also has a damping unit (C1; C1') for damping an oscillation tendency of the device.

9. Device according to claim 8, wherein the damping unit is a capacitor (C1) circuited between the base of the mirror transistor (T3) and a circuit ground (14).

10. Device according to claim 8, wherein the damping unit is a capacitor (C1') circuited between the input (16c) of the feedback unit (T1) and a circuit ground (14).

11. Device according to claim 9 or 10, wherein the capacitor has a capacitance value between 1 and 10 pF.

12. Amplifier circuit comprising:
an amplifier transistor (T4) with a control terminal (10c) and a first and a second terminal (10a, 10b) which are arranged so that a quiescent current can flow through the amplifier transistor (T4) via the first and the second terminal (10a, 10b);
a device for controlling the quiescent current of the amplifier transistor (T4) according to one of the claims 1 to 11,
wherein the first terminal (10c) of the amplifier transistor is connectable to the supply voltage (Vcc);
wherein the second terminal (10b) of the amplifier transistor is connectable to a circuit ground (14);
wherein the control terminal (13c) of the mirror transistor (T3) is connected to the control terminal (10c) of the amplifier transistor (T4); and
wherein a useful signal (RF IN) can be applied to the control terminal (10c) of the amplifier transistor (T4) so that an amplified useful signal can be extracted at the first terminal (10a) of the amplifier transistor.

13. Amplifier circuit according to claim 12, wherein the amplifier transistor (T4) and the mirror transistor (T3) are bipolar transistors.

14. Amplifier circuit according to claim 13, wherein the amplifier transistor (T4) and the mirror transistor (T3) are heterobipolar transistors.

15. Amplifier circuit according to one of the claims 12 to 14, wherein the amplifier transistor (T4) and the mirror transistor (T3) are implemented as a monolithic integrated microwave circuit.

16. Amplifier circuit according to one of the claims 12 to 15, which is completely implemented as a monolithic integrated microwave circuit.

17. Amplifier circuit according to one of the claims 12 to 16, wherein the control terminal (13c) of the mirror transistor (T3) is connected to the control terminal (10c) of the amplifier transistor (T4) via an impedance network (R4, R5, C1).

## Revendications

1. Dispositif de commande d'un courant de repos pour un transistor (T4) amplificateur, le transistor (T4) amplificateur ayant une borne (10c) de commande et une première borne (10a) et une deuxième borne (10b) qui sont disposées de façon à ce que le courant de repos puisse passer dans le transistor (T4) amplificateur par l'intermédiaire de la première et de la deuxième borne (10a, 10b), comprenant les caractéristiques suivantes :
un transistor (T3) de miroir ayant une borne (13c) de commande, une première borne (13a) et une deuxième borne (13b), qui peut être relié au transistor (T4) amplificateur, de façon à ce que le transistor (T3) de miroir forme avec le transistor (T4) amplificateur un miroir de courant, de sorte que le courant de repos du transistor (T4) amplificateur soit égal ou proportionnel au courant passant par les première et deuxième bornes (13a, 13b) du transistor (13) du miroir ;
un dispositif (T21, T22, R1, R2) de détection de la tension sur la première borne (13a) du transistor (T3) du miroir et pour fournir un signal de sortie en réaction à la tension sur la première borne (13a) du transistor (13) de miroir, le dispositif de détection comprenant un amplificateur (T21, T22, R1, R2) différentiel ayant un premier transistor (T21) amplificateur différentiel et un deuxième transistor (T22) amplificateur différentiel, une borne de commande du deuxième transistor (T22) amplificateur différentiel étant reliée à la première borne (13a) du transistor (T3) de miroir, le signal de sortie du dispositif de détection pouvant être envoyé à une borne du premier transistor (T21) amplificateur différentiel et une résistance (R6) est branchée entre un noeud (K), où le premier transistor (T21) amplificateur différentiel est relié au deuxième transistor (T22) amplificateur différentiel et le potentiel de masse ;
un dispositif (T1) de réaction pour recevoir le signal de sortie du dispositif (T21, T22, R1, R2) de détection et pour fournir un signal de réaction qui dépend du signal de sortie du dispositif de détection à la borne (13c) de commande du transistor (T3) du miroir ; et
un dispositif (R3) résistif ayant une deux bornes, une tension (18, 20) pouvant être appliquée à la première borne du dispositif (R3) résistif et la deuxième borne du dispositif (R3) résistif étant reliée à la première borne (13a) du transistor du miroir, de façon à ce qu'un courant passant dans le dispositif (R3) résistif puisse être commandé sur la base de la tension (18, 20) par un signal sur la borne (13c) de commande du transistor (13) du miroir, la tension qui peut être appliquée à la première borne du dispositif (R3) résistif étant une tension Vcc d'alimentation, avec laquelle le dispositif (T1) de réaction et le transistor (T4) amplificateur peuvent être alimentés, et le dispositif de détection peut être alimenté en une tension (22) dont la variation au cours du temps correspond à la variation au cours du temps de la tension (20) Vcc d'alimentation.

2. Dispositif suivant la revendication 1,
dans lequel le dispositif de réaction comprend un transistor (T1) de réaction ayant une borne (16c) de commande et une première et une deuxième borne (16a, 16b), le signal de sortie du dispositif (T21, T22, R1, R2) pouvant être appliqué à la borne (16c) de commande, tandis que la tension (Vcc) d'alimentation du dispositif peut être appliquée à la première borne (16a) et que le signal de réaction peut être émis sur la deuxième borne (16b), et la deuxième borne (16b) est reliée à la borne (13c) de commande du transistor (T3) du miroir.

3. Dispositif suivant la revendication 2, dans lequel le dispositif de réaction comporte un émetteur suiveur ou une source suiveuse.

4. Dispositif suivant l'une des revendications précédentes,
dans lequel le dispositif de détection comprend, en outre, un premier dispositif (R1) résistif et un deuxième dispositif (R2) résistif qui sont montés entre la source (18, 20) de tension et le premier transistor (T21) amplificateur ou le deuxième transistor (T22) amplificateur.

5. Dispositif suivant l'une des revendications précédentes, qui comporte en outre la caractéristique suivante :
un dispositif (I1) d'injection d'un courant supplémentaire dans la première borne (13a) du transistor (T3) du miroir.

6. Dispositif suivant la revendication 5, qui comporte en outre la caractéristique supplémentaire :
un dispositif (30) d'application d'une tension sur la borne de commande du premier transistor (T21) amplificateur différentiel.

7. Dispositif suivant l'une des revendications précédentes,
dans lequel la borne (13c) de commande du transistor (T3) du miroir peut être reliée à la borne (10c) de commande du transistor (T4) amplificateur par l'intermédiaire d'un réseau (R4, R5, C1) d'impédances,
dans lequel la deuxième borne (13b) du transistor du miroir peut être reliée à une masse (14) du circuit, et
dans lequel la deuxième borne (10b) du transistor (T4) amplificateur peut être reliée à la masse (14).

8. Dispositif suivant l'une des revendications précédentes, qui comporte en outre un dispositif (C1 ; C1') d'amortissement pour amortir une tendance à osciller du dispositif.

9. Dispositif suivant la revendication 8, dans lequel le dispositif d'amortissement est un condensateur (C1) qui est monté entre la base du transistor (T3) du miroir et une masse (14) du circuit.

10. Dispositif suivant la revendication 8, dans lequel le dispositif d'amortissement est un condensateur (C1') qui est monté entre l'entrée (16c) du dispositif (T1) de réaction et une masse (14) de circuit.

11. Dispositif suivant la revendication 9 ou 10, dans lequel le condensateur a une valeur de la capacité comprise entre 1 et 10 pF.

12. Circuit amplificateur ayant les caractéristiques suivantes :
un transistor (T4) amplificateur ayant une borne (10c) de commande et une première et une deuxième borne (10a, 10b) qui sont disposées de façon à ce qu'un courant de repos puisse passer dans le transistor (T4) amplificateur par l'intermédiaire de la première et de la deuxième borne (10a, 10b) ;
un dispositif de commande du courant de repos du transistor (T4) amplificateur suivant l'une des revendications 1 à 11,
la tension (Vcc) d'alimentation pouvant être appliquée à la première borne (10c) du transistor amplificateur ;
la deuxième borne (10b) du transistor amplificateur pouvant être reliée à une masse (14) du circuit ;
la borne (13c) de commande du transistor (T3) du miroir étant reliée à la borne (10c) de commande du transistor (T4) amplificateur ; et
un signal (RF IN) utile pouvant être appliqué à la borne (10c) de commande du transistor (T4) amplificateur, de façon à ce qu'un signal utile amplifié puisse être émis sur la première borne (10a) du transistor amplificateur.

13. Circuit amplificateur suivant la revendication 12, dans lequel le transistor (T4) amplificateur et le transistor (T3) de miroir sont des transistors bipolaires.

14. Circuit amplificateur suivant la revendication 13, dans lequel le transistor (T4) amplificateur et le transistor (T3) de miroir sont des transistors hétérobipolaires.

15. Circuit amplificateur suivant l'une des revendications 12 à 14,
dans lequel le transistor (T4) amplificateur et le transistor (T3) de miroir sont réalisés en circuit micro-onde intégré monolithiquement.

16. Circuit amplificateur suivant l'une des revendications 12 à 15, qui est réalisé entièrement sous la forme d'un circuit micro-onde intégré monolithiquement.

17. Circuit amplificateur suivant l'une des revendications 12 à 16,
dans lequel la borne (13c) de commande du transistor (T3) du miroir est reliée par l'intermédiaire d'un réseau (R4, R5, C1) d'impédances à la borne (10c) de commande du transistor (T4) amplificateur.
